# EUROPÄISCHE PATENTSCHRIFT

(11) **EP 2 036 998 B1**
(45) Veröffentlichungstag und Bekanntmachung des Hinweises auf die Patenterteilung: **26.09.2012**
(21) Anmeldenummer: 08020218.7
(22) Anmeldetag: 03.12.2003
(51) Int. Cl.: C23C 14/00, C23C 14/02, C23C 14/08, C23C 14/54

(54) **Verfahren zur Herstellung einer Multilayerschicht und Vorrichtung zur Durchführung des Verfahrens**
Method for producing a multilayer coating and device for carrying out said method
Procédé pour produire un ensemble mutlicouches et dispositif pour mettre en oeuvre ledit procédé

(30) Priorität: 04.12.2002 DE 10256877; 13.10.2003 DE 10347521
(43) Veröffentlichungstag der Anmeldung: 18.03.2009
(62) Teilanmeldung aus: 03812171.1
(73) Patentinhaber: Leybold Optics GmbH, 63775 Alzenau (DE)
(72) Erfinder: Scherer, Michael, Dr., 63796 Kahl (DE); Pistner, Jürgen, 63755 Alzenau (DE); Lehrnert, Walter, 63571 Gelnhausen (DE); Hagedorn, Harro, 60435 Frankfurt am Main (DE); Deppisch, Gerd, 63743 Aschaffenburg (DE); Röder, Mario, 63571 Gelnhausen (DE)
(74) Vertreter: Pohlmann, Bernd Michael

(56) Entgegenhaltungen:
- EP-A- 0 719 874
- US-A- 5 849 162
- US-B1- 6 346 176
- US-B1- 6 440 280

## Beschreibung

Die Erfindung betrifft ein Verfahren zur Herstellung dünner Schichten sowie eine Vorrichtung zur Durchführung des Verfahrens.

Zur Herstellung dünner Schichten sind verschiedenste Verfahren aus dem Bereich physikalischer und chemischer Abscheidetechniken bekannt. Abhängig von den gewünschten Eigenschaften der abzuscheidenden Schicht und des gewählten Materialsystems werden unterschiedliche Verfahren eingesetzt.

Insbesondere für Materialien mit hohem Schmelzpunkt ist die Methode der Kathodenzerstäubung (Sputtem) vorteilhaft, bei der in einem Vakuumbereich, der deutlich über einem typischen Restgasdruck für ein Aufdampfverfahren liegt, durch Einwirken eines elektrischen Feldes ein Plasma gezündet wird, aus dem Ionen auf ein auf hohem elektrischen Kathodenpotential liegendes Target beschleunigt werden und diese Ionen Atome aus dem Target heraus schlagen, welche sich sodann auf den Wänden der Vakuumkammer und auf einem zum Target beabstandeten, üblicherweise auf Masse oder einer geringen Biasspannung liegenden Substrat niederschlagen. Ein Erhitzen der Materialquelle ist dabei nicht notwendig, vielmehr wird das Target beim Prozess gekühlt. Dabei resultiert ein Restgasdruck üblicherweise überwiegend aus einem Inertgas wie etwa Argon, welches keine störenden Einflüsse auf die sich auf dem Substrat bildende Schicht zeigt. Zur Abscheidung von Verbindungen wie Nitride, Carbide oder Oxide oder dergleichen können dem Sputtergas zusätzlich entsprechende Reaktivkgase beigemischt werden.

Das Substrat wird üblicherweise ausserhalb der Plasmazone angeordnet, um eine Schädigung der frisch aufwachsenden Schicht durch Bestrahlung aus dem Plasma oder Rücksputtereffekte zu vermeiden. Die mittlere freie Weglänge der Ionen muss gross genug sein, um mit ausreichender kinetischer Energie, d.h. mit möglichst wenig Störungen durch weitere Stossprozesse im Restgas, auf das Target zu gelangen und andererseits die zerstäubten Atome auf das Substrat gelangen zu lassen, was den möglichen Restgasdruck nach oben begrenzt. Andererseits muss der Druck hoch genug sein, um überhaupt ein stabiles Plasma zünden zu können. Durch magnetfeldunterstützes Kathodenzerstäuben gelingt es, am Target eine erhöhte Elektronendichte zu erzeugen, die in einer hohen Plasmadichte am Target und daher in einer stark erhöhten Zerstäubungsrate resultiert.

Durch Zufügen reaktiver Komponenten, insbesondere Sauerstoff, zum Inertgas können auch Oxide hergestellt werden. Ein solches reaktives Zerstäubungsverfahren ist z.B. aus der WO 01/73151 A1 bekannt. Dort wird der Sauerstoffpartialdruck beim Sputtern des Oxids mittels einer Lambda-Sonde geregelt, damit sich in der aufwachsenden Schicht ein stöchiometrisches Oxid bilden kann. Allerdings reagiert auch das Target mit dem Reaktivgas, so dass konkurrierende Verfahren, nämlich Abtrag einerseits und eine die Abtragung hemmende Oxidbildung an der Targetoberfläche ablaufen. Dies hat wiederum Rückwirkungen auf die elektrischen Potentiale in der Beschichtungskammer, die Plasmabildung und dergleichen. Ebenso bilden die sich auf den inneren Oberflächen der Vakuumkammer abscheidenden Schichten des zerstäubten Materials Getterflächen, welche z.B. Sauerstoff als Reaktivkomponente binden und so zu einer gegenseitigen, schwer vorhersagbaren Abhängigkeit verschiedenster Verfahrensparameter führt. Auch hier ist also der Zusammenhang zwischen den Beschichtungsparametern sehr komplex. Häufig kommt es dabei zu gegenseitiger Beeinflussung, wenn ein einzelner Beschichtungsparameter verändert wird. Je nach abzuscheidendem Schichtmaterial ist es daher notwendig, die Beschichtungsverfahren und die Beschichtungsparameter individuell aufeinander abzustimmen. Dies gilt umso mehr, je komplexer ein abzuscheidendes Schichtsystem ist, etwa bei der Abscheidung von Multischichten mit speziellen Funktionseigenschaften, insbesondere optischen Funktionsschichten. Die erwähnten Probleme sind besonders stark ausgeprägt bei dem sogenannten reaktiven DC-Magnetron-Sputtering von metallischen Verbindungen, bei dem die Forderung nach einer reaktiven Verbindung auf der Substratoberfläche bei gleichzeitiger metallischer Targetoberfläche nur mit hohem Aufwand erreichbar ist. Zur Herstellung von isolierenden Schichten, wie z.B. SiO₂, Al₂O₃ und dergleichen sind daher bereits auch Verfahren entwickelt worden, bei denen mittels jeweils zwei Magnetron-Sputterkathoden, die von einer Wechselstromquelle gespeist werden, zwei Targets alternierend eingesetzt werden. Die Polaritäten der Targetpotentiale ändern sich üblicherweise im KHz Bereich, d.h. jede Elektrode ist abwechselnd Kathode und Anode. Dies führt zu einem definierten Ladungstransport zwischen Kathode und Anode ohne hemmenden Einfluss einer Oxidschicht an den Targetoberflächen, im Gegensatz zum störenden Effekt der sogenannten "disappearing anode" beim reaktiven DC-Magnetron-Sputtering.

Ein effizienter Betrieb setzt dabei jedoch voraus, dass in dem sogenannten Übergangsbereich gearbeitet wird, da ansonsten die Oxidbildung an der Targetoberfläche schneller als die Abtragrate ist.

Aus der EP 0 795 623 A1 ist eine Vorrichtung zum Aufbringen dünner Titanoxidschichten mittels reaktiver Kathodenzerstäubung bekannt. Dabei wird die Stromversorgung der Kathode durch ein Signal eines λ-Sonden-Messfühlers, der den Anteil von Sauerstoff in der Vakuumkammer mit einem Referenzgas vergleicht, geregelt. Das Verfahren eignet sich besonders zur langzeitstabilen Abscheidung von Oxiden, die möglichst homogen und mit gleichbleibender Zusammensetzung hergestellt werden sollen.

Aus der DE 42 36 264 C1 ist ein plasmagestütztes Elektronenstrahlbedampfen bekannt, bei dem ein Oxid mit sehr hoher Rate mittels eines Elektronenstrahlverdampfers verdampft und auf einem Substrat abgeschieden wird. Beim Verdampfen dissoziiert jedoch das Oxid, so dass Sauerstoff verloren geht und nicht mehr zur Oxidbildung in der aufwachsenden Schicht zur Verfügung steht. Zwischen Substrat und Verdampfungsquelle befindet sich daher ein Plasmaraum mit einem Sauerstoffplasma, in dem der Dampf auf dem Weg zum Substrat angeregt wird, so dass sich auf dem Substrat ein stöchiometrisches Oxid niederschlagen kann. Je nach Materialsystem gelingt die Abscheidung eines stöchiometrischen Oxids, indem entweder der Partialdruck des Reaktivgases oder die Plasmaparameter während der Beschichtung geregelt werden. Dabei sind die Zusammenhänge sehr komplex und von einem Materialsystem auf ein anderes kaum übertragbar. Eine Variation einzelner Verfahrensparameter führt bei verschiedenen Materialsystemen zu unterschiedlichen Ergebnissen. Optimierte Abscheideparameter für z.B. Aluminiumoxid führen nicht zu optimalen Ergebnissen z.B. bei Siliziumoxid. Darüber hinaus zeigen sich auch innerhalb ein- und desselben Materialsystems Langzeitdriften verschiedener nicht getrennt erfassbarer Verdampfungsparameter, die zu unerwünschten Änderungen der Eigenschaften der abgeschiedenen Schichten führen und die Reproduzierbarkeit eines eingefahrenen Beschichtungsprozesses zusätzlich erschweren.

Aus der EP 01516 436 E1 ist eine Magnetron-Sputtervorrichtung zur reaktiven Abscheidung eines Materials auf ein Substrat bekannt mit einer Magnetron-Sputtereinrichtung und einer sekundären Plasmaeinrichtung. Die Sputtereinrichtung und die sekundäre Plasmaeinrichtung bilden jeweils Sputter- und Aktivierungszonen, die atmosphärisch und physikalisch benachbart sind. Durch das Zusammenbringen der Sputter- und Aktivierungszone werden die Plasmen beider Zonen zu einem einzigen kontinuierlichen Plasma vermischt.

Aus der EP 0 716 160 B1 ist eine Beschichtungsvorrichtung bekannt mit einer Abscheidungsvorrichtung und einer Vorrichtung zum Erzeugen eines Plasmas von Ionenniedriger Energie. Die Abscheidungs- und Plasmavorrichtungen können selektiv betrieben werden, so dass eine Kompositschicht gebildet wird, die mindestens mehrere Schichten aufweist. Die Zusammensetzung einer jeden Schicht kann aus mindestens einer der folgenden Substanzen ausgewählt sein: ein erstes Metall, ein zweites Metall, ein Oxid des ersten Metalls, ein Oxid des zweiten Metalls, Mischungen des ersten und zweiten Metalls und Oxide von Mischungen des ersten und zweiten Metalls.

Die US 6,440,280 B1 zeigt eine Vorrichtung zum Beschichten von Substratscheiben, die auf der Außenfläche einer drehbaren Trommel angeordnet sind und durch Drehung dieser Trommel an einer Sputtereinheit und der Sputtereinheit benachbarten Plasmaquellen entlangbewegt werden können.

Die US 6,346,176 B1 offenbart eine Vorrichtung mit einer Kammer, in der eine Sputterstation und eine Oxidationsstation mit einer Plasmaquelle angeordnet sind. Sputterstation und Oxidationsstation befinden sich in örtlich getrennten Bereichen dieser Kammer. Die Vorrichtung dient zur Behandlung eines Substrats, welches mit Hilfe einer Transportvorrichtung zwischen der Sputterstation und der Plasmaquelle bewegt werden kann. Zwischen in Sputterstation und Oxidationsstation keine Blenden vorgesehen, die diese beiden Stationen gegeneinander abschirmen.

Aus der US 5,849,162 ist eine Vorrichtung zum plasmaunterstützten Sputtern stöchiometrischer Schichten bekannt. Die Vorrichtung enthält eine Magnetonsputteranlage und eine Plasmaquelle, die in einer solchen Weise relativ zueinander angeordnet sind, dass ihre Wirkungsbereiche überlappen und sie ein "continuous activating and sputtering plasma" bilden. Die technische Lehre basiert darauf, dass das Plasma der Plasmaquelle möglichst ungehindert in den Wirkungsbereich der Sputteranlage eindringen kann.

Die EP 719 874 A1 offenbart eine Vorrichtung zum Beschichten eines Substrats, wobei zunächst in einer Sputterstation eine metallische Schicht auf das Substrat aufgetragen wird, die anschließend in einer Plasmazone oxidiert wird. Die Zonen sind durch Blenden gegeneinander abgeschirmt, so dass in die Sputterstation kein Reaktivgas eindringen kann.

Aufgabe der Erfindung ist es, ein Verfahren zur Herstellung dünner Schichten anzugeben, mit dem zuverlässig in situ die Zusammensetzung der Schicht kontrolliert beeinflusst werden kann sowie eine Vorrichtung zur Durchführung des Verfahrens zu schaffen.

Die Aufgabe wird mit jeweils den Merkmalen der unabhängigen Ansprüche gelöst.

Gegenüber dem aus dem Stand der Technik bekannten Aufoxidieren metallischer Schichten oder Halbleiterschichten, erlaubt insbesondere die gezielte Abscheidung einer substöchiometrischen Schicht im Bereich einer Sputtereinrichtung eine Steigerung der Beschichtungsrate, da die nachfolgende Plasmaeinwirkung dickere Schichten in kürzerer Zeit zum stöchiometrischen Oxid oxidieren kann. Ferner erlaubt die erfindungsgemäße reaktive Abscheidung einer Schicht mit einer vorgegebenen Schichtdicke mit einem optischen Verlust, der einen vorgegebenen Mindestwert unterschreitet, und nachfolgender Plasmaeinwirkung eine relativ schnelle Herstellung von Schichten mit geringen optischen Verlusten. Im Vergleich zu bekannten reaktiven Sputterprozessen kommt der Sputterprozeß weniger durch Störungen wie Überschläge oder Kathoden-Arcing zum Erliegen während gleichzeitig Schichten hoher Qualität gebildet werden.

Das erfindungsgemäße Verfahren geht von der Erkenntnis aus, dass die abgeschiedenen Schichten möglichst eine vollständige Stöchiometrie zwischen einem ersten Konstituenten und einer reaktiven Konstituenten aufweisen sollte. Erfindungsgemäß wird dabei der reaktive Sputterprozess in einem Modus kontrollierter Substöchiometrie betrieben und in einem zweiten Schritt der fehlende Anteil des reaktiven Konstituenten durch die Wirkung der zusätzlichen Plasmaquelle zur Verfügung gestellt. Beispielsweise ist die Sequenz zur Herstellung von stöchiometischen SiO₂-Schichten wie folgt: In einem ersten Schritt erfolgt eine Sputterbeschichtung unter Verwendung eines metallischen Siliziumtargets, wobei ein Reaktivgasfluss von Sauerstoff eingesetzt wird und zu einer substöchiometrischen Verbindung einer Schicht von beispielsweise SiO_{1.6} führt. Der zugehörige Wert des Defizits der Reaktivkomponente DEF ist dann 0.4. In einem zweiten Schritt erfolgt eine Plasmaaktivierung mit Sauerstoff als Reaktivgas, was zu einer vollständig stöchiometrischen SiO₂-Schicht führt.

Die Abscheidung derartiger Schichten wird durch Parameter bestimmt, die materialabhängig sind. Hierbei ist es erfingdungsgemäß stets möglich, einen optimalen Kompromiss zwischen einer hohen Sputterrate und einer maximal erreichbaren Stöchiometrie im ersten Schritt kombiniert mit einer maximal effektiven anschließenden Behandlung durch die Plasmaquelle im zweiten Schritt zu gewährleisten.

Mit dem erfindungsgemäßen Verfahren gelingt die Abscheidung dünner Schichten mit hoher Präzision und ausgezeichneter Güte. In einer besonders bevorzugten Ausführungsform gelingt die Herstellung oxidischer, carbidischer und nitridischer Schichten mit hoher optischer Güte.

Weitere Ausgestaltungen und Vorteile der Erfindung sind den weiteren Ansprüchen sowie unabhängig von ihrer Zusammenfassung in den Ansprüchen der Beschreibung zu entnehmen.

Die Erfindung wird anhand von Zeichnungen näher beschrieben, wobei die Figuren in schematischer Darstellung zeigen:
- Fig. 1: Eine Prinzipdarstellung einer bevorzugten Anordnung von Substrat, Target und Plasmaquelle zur Oxidation einer Schicht.
- Fig. 2 bis Fig. 5: Kennlinien bei einer reaktiven Kathodenzerstäubung.
- Fig. 6: Ein Beispiel der optischen Transmission einer Schicht als Funktion der Wellenlänge mit und ohne rf-Plasmaquelle als Parameter der Kurvenschar.
- Fig. 7: Ein Beispiel der optischen Transmission einer Schicht als Funktion der Wellenlänge mit der Substratgeschwindigkeit als Parameter der Kurvenschar.
- Fig.8: Zeigt Beispiele für optische Verluste von Einzelschichten mit unterschiedlichen Schichtdicken.

Mit dem erfindungsgemäßen Verfahren können durch reaktives Sputtern ohne das Vakuum zu brechen Schichten mit geringen optischen Verlusten hergestellt werden, welche Reaktionskomponenten wie Sauerstoff, Kohlenstoff oder Stickstoff enthalten. Im Folgenden wird eine Oxidherstellung beschrieben; das Verfahren ist jedoch auch für Carbide oder Nitride oder Mischungen wie Oxinitride oder Carbonitride oder dergleichen geeignet, wobei auch 2 oder mehr reaktive Gase (Reaktivgase) als Reaktivkomponente gleichzeitig benutzt werden können.

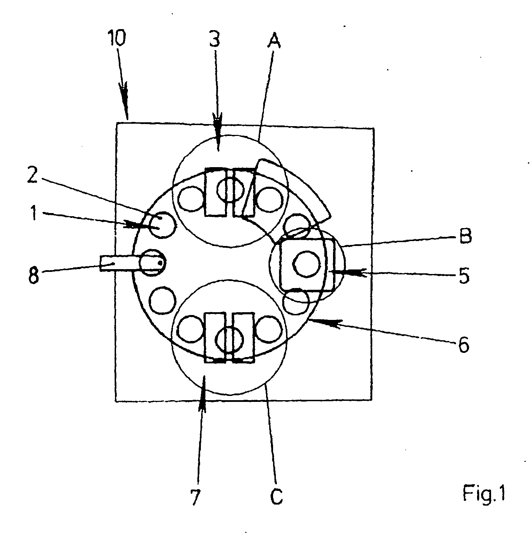

Fig. 1 zeigt eine schematische Skizze einer bevorzugten Anordnung zur Abscheidung einer Schicht gemäß einer Ausführungsform der Erfindung. Eine Oxidschicht 1 wird in einer Vakuumkammer 10 mit einem Restgas auf einem Substrat 2 abgeschieden. Die Vakuumkammer 10 ist in mehrere Bereiche A, B, C eingeteilt. Jeder Bereich A, B, C hat eine eigene, nicht dargestellte Gaszuführung, sowie eine eigene Pumpenversorgung. Vorzugsweise ist das Vakuum kohlenwasserstofffrei und wird mit einem trockenlaufenden Pumpensatz erzeugt. Es können auch mehr als drei solcher Bereiche vorgesehen sein. Die Bereiche A, B, C sind voneinander mit Blenden abgeteilt, die nur durch Schlitze miteinander verbunden sind. Damit wird eine vakuummäßige Trennung von im Folgenden noch näher beschriebenen Prozessstationen, nämlich Sputtereinrichtungen bzw. eine Plasmaquelle, in den Bereichen A, B, C erreicht. Die Prozessstationen sind plasmamässig entkoppelt. Die Drücke, einschließlich der Partialdrücke von Gasen im Restgas (Sputtergas) der Anlage können im wesentlichen unabhängig voneinander eingestellt werden. Vorzugsweise ist ein Inertgas wie Argon Ar und ein Reaktivgas, vorzugsweise Sauerstoff O₂ im Restgas enthalten.

Im Bereich A ist als Sputtereinrichtung 3 eine erste Kathodenzerstäubungsquelle vorgesehen, vorzugsweise eine Magnetronquelle, besonders bevorzugt ein an sich bekanntes Magnetronquellensystem mit zwei nebeneinander liegenden Magnetronanordnungen, auch als Twinmag bekannt. Die Stromversorgung kann eine Versorgungseinheit mit DC-, DC-Puls- oder Mittelfrequenz- (MF) oder Hochfrequenz- (HF) oder eine kombinierte DC-HF-Versorgung sein. Typische Spannungsbereiche der Sputterkathode sind 400V bis 800V. Vorzugsweise wird eine MF-Quelle mit 40 kHz eingesetzt.

In dem Bereich A wird mittels reaktivem Sputtern ein Sputtermaterial eines Targets zerstäubt, wobei sich jeweils mit einer arbeitspunktabhängigen Sputterrate ein Sputtermaterial-Sauerstoff-Verbund an Wänden der Vakuumkammer 1 und auf den Substraten 2 niederschlägt. Bevorzugte Sputtermaterialien sind Metalle und Metalllegierungen wie Al, Nb, Hf, Ta, Ti, Zr, TiNb sowie Halbleiter wie Si.

Im Bereich B ist eine Plasmaquelle 5 angeordnet, die ein Plasma erzeugt, welches angeregte Ionen und Radikale des reaktiven Bestandteils des Restgases enthält. Die reaktiven Teilchen wirken auf die abgeschiedene Schicht ein und oxidieren diese weiter. Die Plasmaquelle 5 kann beispielsweise eine DC-, HF- MF- oder DC-Puls- oder DC+HF-Mikrowellen-Plasmaquelleneinrichtung, insbesondere eine Hall End Plasmaquelle, eine Heisskathoden DC-Plasmaquelle, eine Hochfrequenz-Plasmaquelle, eine Mittelfrequenz- oder eine gepulste DC-Plasmaquelle sein. Die Energie der Plasmaquelle 5 ist einstellbar, vorzugsweise auf einen Bereich 10 eV bis 200 eV oder auch 400eV. Vorzugsweise wird eine ECWR-Plasmaquelle (Electron-Cyclotron-Wave-Resonance) eingesetzt, bei der die Energie der Plasmateilchen weitgehend unabhängig von der Plasmadichte in der Plasmaquelle 5 eingestellt werden kann.

In einem Bereich A der Vakuumkammer 10, vorzugsweise zwischen den beiden Bereichen A und B, kann eine Heizvorrichtung angeordnet sein, vorzugsweise eine Strahlungsheizung mit Quarzstrahlern. Alternativ können auch Infrarot-Strahler vorgesehen sein. Damit können die Substrate auf mehrere hundert Grad erhitzt werden, beispielsweise auf 250°C.

Ferner ist ein Bereich C vorgesehen, in dem eine zweite Kathodenzerstäubungsquelle 7 diametral gegenüberliegend angeordnet ist, welche vorzugsweise wie die erste Kathodenzerstäubungsquelle 3 ausgebildet ist. In einer weiteren Ausführungsform sind weitere Sputtereinrichtungen und/oder Plasmaquellen in der Vakuumkammer vorgesehen.

Räumlich zwischen den Bereichen A und C ist eine optische Messeinrichtung (optischer Monitor) 8 zum optischen Monitoring angeordnet, mittels der optische Eigenschaften der aufwachsenden Schichten bestimmt werden können. Bevorzugt werden, wie an sich bekannt, Transmission und/oder Reflexion einer Schicht intermittierend auf mindestens einem der Substrate zur Ermittlung von optischen Eigenschaften der aufgebrachten Schicht gemessen. Damit kann insbesondere auch die aufwachsende optische Schichtdicke überprüft werden.

Eine vorzugsweise planare Transporteinrichtung 6 bewegt ein Substrat 2 mindestens einmal nacheinander an mindestens einer Kathodenzerstäubungsquelle 3, 7 und an mindestens einer Station mit einer Plasmaquelle 5 vorbei. Dabei ist die Transporteinrichtung 6 vorzugsweise ein Substrat-Drehteller mit einer einstellbaren Geschwindigkeit von beispielsweise 1 bis 500 rpm. Die Beschleunigung auf hohe Solldrehzahlen kann in wenigen Stufen und jeweils innerhalb desselben Bereichs A, B, C erfolgen. Anstelle einer planaren Transporteinrichtung kann auch eine an sich bekannte trommelförmige Einrichtung zur Halterung und zum Transport der Substrate eingesetzt werden. In diesem Fall sind Sputtereinrichtung und Plasmaquelle einem peripheren Oberflächenbereich der Trommel zugeordnet.

Üblicherweise werden ein oder mehrere Substrate 2 auf dem Drehteller 6 befestigt. Der Übersichtlichkeit wegen ist nur eines der in der Figur 1 als Kreis gezeigten Substrate mit einem Bezugszeichen bezeichnet.

In der Vakuumkammer 10 wird das Substrat 2 von dem Drehteller 6 unter die erste Kathodenzerstäubungsquelle 3 bewegt. Dort wird durch Kathodenzerstäubung das Target zerstäubt, wobei sich aus dem Target herausgeschlagenes Material auf dem Substrat niederschlägt. Als Sputtergas wird in einer bevorzugten Ausführungsform der Erfindung ein Argon-Sauerstoffgemisch verwendet, so dass die auf dem Substrat 2 aufwachsende Schicht 1 ein Oxid ist.

Gemäß der Erfindung wird der Kathodenzerstäubungsprozess so betrieben, dass in dem Bereich A bzw. C unter Zuführung einer Reaktivkomponente gezielt eine Verbindungsschicht mit vorgegebener Zusammensetzung abgeschieden wird. Die Schicht 1 wird mit zumindest zwei Konstituenten gebildet, wobei der reaktive Bestandteil O₂ einen der Konstituenten bildet und, bezogen auf den Bestandteil O₂, die Schicht 1 substöchiometrisch hergestellt. Bezogen auf eine stöchiometrische Verbindung der Konstituenten wird die Schicht 1 mit einem vorgegebenen Defizit, beispielsweise von höchstens 90, 80, 70, 60, 50, 40, 30, 20 oder weniger Atomprozent des reaktiven Bestandteils O₂ abgeschieden. Anschließend wird in dem Bereich B der Gehalt des Bestandteils O₂ in situ mittels einer Plasmaeinwirkung auf die Schicht 1 in der Schicht 1 bis zur stöchiometrischen Zusammensetzung erhöht und/oder die Struktur der Schicht modifiziert. Statt des reaktiven Bestandteils O₂ kann im Bereich B auch ein anderes reaktives Gas zugeführt werden.

Besonders günstig ist es, wenn der Partialdruck des Bestandteils O₂ in dem Bereich der Kathodenzerstäubungsquelle 3 während der Beschichtung des Substrats 2 auf einen im Wesentlichen konstanten Wert geregelt wird. Günstigerweise wird der Partialdruck des Bestandteils O₂ über dessen Gasfluss eingestellt. Es ist auch möglich, den Sauerstoffpartialdruck über die elektrische Leistung der Kathodenzerstäubungsquelle 3 konstant einzustellen, wobei die Rate über die Targetlebensdauer in besonders hohem Masse konstant gehalten werden kann.

Weiterhin kann in dem Bereich A der Kathodenzerstäubungsquelle 3 während der Beschichtung des Substrats 2 eine Intensität einer Plasmaemissionslinie, vorzugsweise einer Emissionslinie für das Targetmaterial, des reaktiven Bestandteils oder eine Kombination beider auf einen wesentlichen Konstantwert geregelt werden. Dieses kann über den Gasfluss des Bestandteils O₂ und/oder die elektrische Leistung der Kathodenzerstäubungsquelle 3 eingestellt werden.

Die Schichteigenschaften können auch variiert werden, indem die Geschwindigkeit, mit der das Substrat 2 an der Plasmaquelle 5 und/oder der Kathodenzerstäubungsquelle 3 vorbei geführt wird, verändert wird.

Eine Schicht kann erfindungsgemäß auch über mehrere Zwischenschritte durch unterstöchiometrische Abscheidung/Oxidation hergestellt werden. Weiterhin können Mehrfachschichten abgeschieden werden, bei denen durch Variation der Schichtparameter in Einzellagen wechselnde Brechungsindizes entlang einer aufwachsenden Gesamtschicht erzielt werden. Solche Mehrfachschichten können beispielsweise kontrolliert abgeschieden werden, indem die Beschichtungs- und/oder Oxidationszeit, und/oder die Anzahl der Rotationen eingestellt wird und/oder über die optische Messeinrichtung 8 die Beschichtung anhand der optischen Eigenschaften der aufwachsenden Schicht oder Schichtfolge gesteuert wird.

Gemäß einer anderen Ausführungsform der Erfindung wird in dem Bereich A der Kathodenzerstäubungsquelle 3 unter Hinzufügung einer vorgegebenen Menge der Reaktivkomponente auf dem Substrat eine Schicht mit einer vorgegebenen Schichtdicke abgeschieden, die optische Verluste geringer als ein vorgegebener Mindestwert aufweist. Als optischer Verlust wird dabei in an sich bekannter Weise die im Allgemeinen wellenlängenabhängige Dämpfung einer auf eine Schicht einfallenden Lichtwelle bezeichnet. Die optischen Verluste können aus Messungen der Transmission und Reflektion ermittelt werden. Da das Streulicht durch diffuse Streuung in einem Zusammenhang mit der Rauhigkeit einer Oberfläche steht, lassen sich aus den optischen Verlusten einer Schicht auch Rückschlüsse auf die Oberflächenbeschaffenheit ziehen. Bevorzugt werden erfindungsgemäß die optischen Verluste mittels der optischen Messeinrichtung (optischer Monitor) 8 bestimmt. Der optische Monitor 8 ist besonders bevorzugt als ein Einwellenlängen- oder Mehrwellenlängen Spektrometer, insbesondere als Spektralfotometer oder Ellipsometer, besonders bevorzugt Spektralellipsometer ausgebildet. Es werden nach Abscheidung einer vorgegebenen Schichtdicke, die optischen Verluste ermittelt und es folgt eine Einstellung von Schichteigenschaften in Abhängigkeit von einem Signal des optisches Monitors 8. Bei Einsatz eines Spektralfotometers können in einfache Weise Transmission, Absorption und Reflektion in einem vorgegebenen Spektralbereich und als Funktion der Schichtdicke ermittelt werden.

Im Folgenden wird für eine bevorzugte Ausführungsform des erfindungsgemäßen Verfahrens die Prozessführung zur Herstellung einer Schicht durch reaktives Sputtern mit einer anschließenden Modifikation der aufgebrachten Schicht beschrieben. Andere Prozessführungen sind ebenfalls von der Erfindung umfasst. Als Sputtereinrichtung wird ein Magnetronquellensystem mit zwei nebeneinander liegenden Magnetronanordnungen mit zwei Niob-Targets eingesetzt. Die Targets werden in einem MF - Bereich, beispielsweise mit einer Frequenz von 40 kHz alternierend betrieben. Beiden Targets sind Shutter zugeordnet, mit denen die Sputtereinrichtung gegenüber den Substraten isoliert werden kann. Die Plasmaquelle, welcher ebenfalls ein Shutter zugeordnet ist, wird in einem Radiofrequenzbereich angesteuert.

In einem ersten Schritt wird die Sputtereinrichtung in einen Arbeitspunkt eingestellt, wobei zur Stabilisierung des Prozesses die Shutter geschlossen sind. Es erfolgt ein Einlass von einem Inertgas und einer Reaktivkomponente (beispielsweise Argon und Sauerstoff) in dem Bereich der Sputtereinrichtung. Ferner folgt ein Einlass von einem Inertgas und einer Reaktivkomponente in den Bereich der Plasmaquelle. Der Substratträger, beispielsweise ein planarer Drehteller, wird auf eine Sollgeschwindigkeit beschleunigt. In einem weiteren Schritt wird das Plasma der Plasmaquelle gezündet. Es erfolgt ferner eine Zündung des Sputterplasmas der Kathodenzerstäubungseinrichtung, die auf eine vorgegebene Sollleistung gebracht wird. Anschließend wird eine Partialdruckregelung im Bereich der Sputtereinrichtung aktiviert. Vorzugsweise wird ein vorgegebener Partialdrucksollwert über die Kathodenleistung stabilisiert.

In einem zweiten Schritt wird mit der Beschichtung der Substrate begonnen. Hierzu werden die Shutter geöffnet. Dabei hat sich gezeigt, dass nur eine geringe Änderung der im Arbeitspunkt eingestellten Regelungsparameter durch die Öffnung der Shutter notwendig ist. Eine gewünschte Schichtdicke kann über eine Beschichtungszeit bzw. eine Anzahl von Rotationen kontrolliert werden. Besonders bevorzugt ist eine in situ erfolgende optische Schichtdickenmessung durch den optischen Monitor 8.

Erfindungsgemäß erfolgt die reaktive Abscheidung einer Schicht in einem Arbeitspunkt einer Kennlinie oder eines Kennfeldes, der Sputtermaterial- und reaktivkomponentenmaterialabhängig zur Minimierung eines optischen Verlustes der abgeschiedenen Schicht oder der durch Plasmaeinwirkung modifizierten Schicht gewählt wird. Im Folgenden werden einige bevorzugte Kennlinien dargestellt.

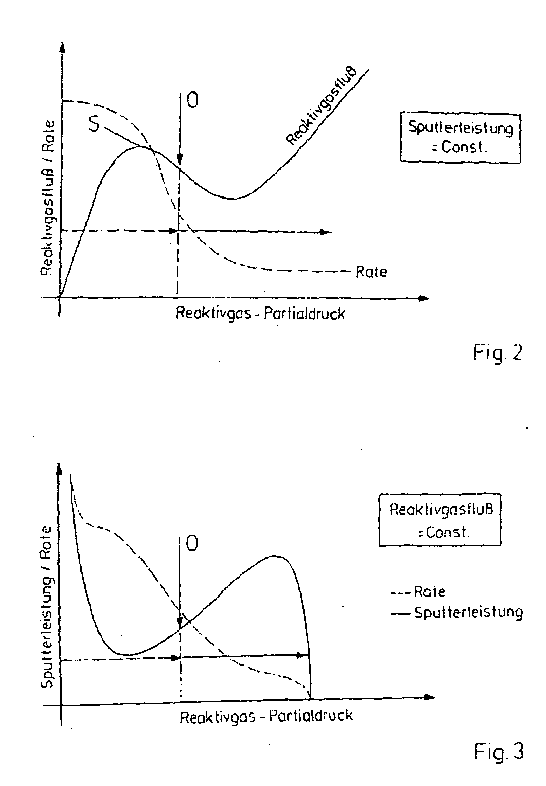

In Fig. 2 ist eine Kennlinie der Abhängigkeit eines Reaktivgasflusses von einem Partialdruck der Reaktivkomponente bei einem Kathodenzerstäubungsprozess in einem Beispiel mit einem Aluminiumtarget und mit Sauerstoff als reaktivem Bestandteil und konstanter Leistung der Sputtereinrichtung (Sputterleistung) angegeben. Bei kleinen Werten des Partialdrucks steigt der Sauerstofffluss zuerst steil an und fällt nach einem Scheitelpunkt S ab, um bei höherem Partialdruck nach einem Minimum wieder anzusteigen. Bei sehr niedrigem Sauerstoffpartialdruck stellt sich ein Zustand mit einer weitgehend metallischen Targetoberfläche ein, wobei metallische Schichten auf dem Substrat deponiert werden. Wird der Sauerstoffpartialdruck über einen Wert, der dem Scheitelpunkt entspricht, erhöht, folgt bei flußgeregeltem Prozess ein Übergang zu einem Oxid- oder Compound-mode, bei der die Targetoberfläche vollständig mit Reaktionsprodukten belegt ist und stöchiometrische Schichten mit ungünstigen Schichteigenschaften auf dem Substrat aufwachsen. Der mit O bezeichnete Pfeil gibt den Übergang zu dem Oxid- oder Compound-mode an. Die gestrichelte Kurve in Figur 2 beschreibt die zugehörige Abscheidungsrate. Es ist ersichtlich, dass diese bei einem niedrigen Reaktivgaspartialdruck maximal ist und bei wachsendem Reaktivgaspartialdruck abfällt, bis sie in einen Sättigungsbereich parallel zur Abszisse kommt. Vom oxidischen her kommend, findet der Übergang in den metallischen Bereich erst bei niedrigerem Sauerstoff-Partialdrücken statt, so dass die Kennlinie eine Hysterese aufweist. Der Bereich zwischen dem Scheitelpunkt und dem Minimum der Kennlinie ist im allgemeinen nicht ohne aufwendige Regelungsmaßnahmen zugänglich, ermöglicht jedoch die Abscheidung von substöchiometrischen Schichten mit einer hohen Abscheidungsrate. Das erfindungsgemäße Verfahren wird vorzugsweise in einem vorgegebenen Bereich der Kennlinie mit ansteigendem oder abfallendem Gasfluss nahe des Scheitelpunktes S durchgeführt, da hier relativ hohe Sputterraten erreicht werden können. Besonders bevorzugt ist der Bereich nahe dem Scheitelpunkt S der Kennlinie, mit einem Gasfluss des ersten Bestandteils O₂ welcher bei der Abscheidung der Schicht 1 höchstens um 50%, unterhalb des Maximalwerts im Scheitelpunkt S, besonders bevorzugt höchstens 20% bis 10% unterhalb des Maximalwerts im Scheitelpunkt S liegt. In diesem Bereich ist eine hohe Abscheidungsrate einer substöchiometischen Schicht erreichbar, die anschließend einer Plasmaeinwirkung ausgesetzt wird. Materialabhängig, z. B. bei Ti, Nb, TiNb kann erfindungsgemäß in dem Übergangsbereich rechts des Scheitelpunktes S gearbeitet werden, während für andere Materialien, z. B. Al, Si der Bereich links des Scheitelpunktes S bevorzugt wird.

In Fig. 3 ist analog eine Kennlinie bei einem konstant gehaltenen Reaktivgasfluss dargestellt, bei der ein Sollwert eines Reaktivgaspartialdrucks mit Hilfe der Sputterleistung eingestellt wird. Der substöchiometrische Bereich liegt hier links des mit O bezeichneten Pfeils. Bei diesem Regelungsverfahren wird erfindungsgemäß bevorzugt, jedoch nicht ausschließlich in einem Bereich um das Minimum der Kennlinie gesputtert.

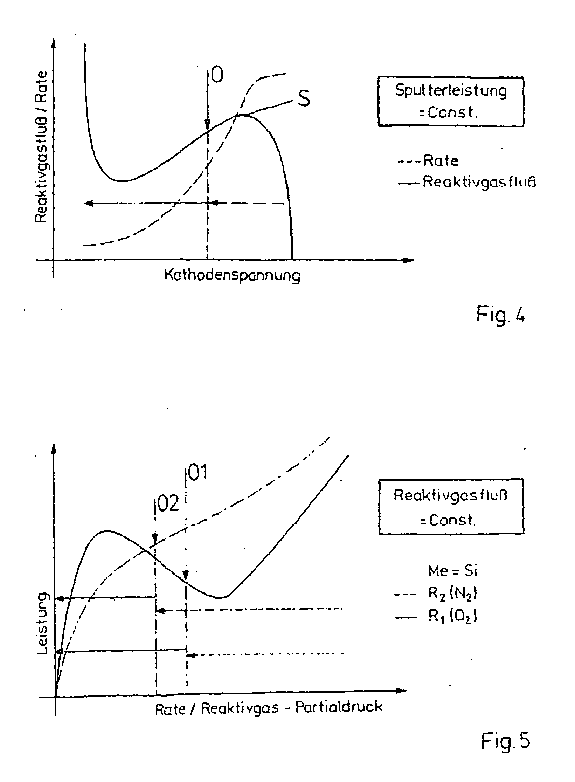

In Fig. 4 ist eine weitere Kennlinie dargestellt, bei der bei konstanter Sputterleistung ein Sollwert einer Sputterkathodenspannung mit Hilfe eines Reaktivgasflusses und in dem Bereich rechts des mit O bezeichneten Übergangs zu einer substöchiometrischen Verbindung eingestellt wird. Bevorzugt ist hier ein Bereich um das Maximum S des Übergangs.

Ein konstanter Reaktivgasfluss wird bei der in Fig. 5 dargestellten Kennlinie verwendet, wobei ein Sollwert eines Quotienten aus einer Sputterrate und einem Reaktivgaspartialdruck mit Hilfe der elektrischen Leistung der Sputtereinrichtung auf einen vorgegebenen Sollwert geregelt wird. Die durchgezogene Kurve bezeichnet hierbei die Kennlinie bei Sauerstoff als Reaktivgas, während die gestrichelte Kurve die Kennlinie bei Stickstoff als Reaktivgas bezeichnet. Die mit 01 bzw. 02 bezeichneten Pfeile geben den Übergang von einem substöchiometrischen rechts des Übergangs zu einem stöchiometrischen Regime links des Übergangs jeweils für Sauerstoff bzw. Stickstoff als Reaktivgas an. Ersichtlich ist, dass die Position dieses Übergangs von dem verwendeten Reaktivgas abhängig ist. Ferner ist das im Fall von Sauerstoff rechts des erwähnten Übergangs bei 01 liegende Minimum in der entsprechenden Kennlinie für Stickstoff verschwunden; dem entspricht ein Fehlen einer Hysterese. Der Quotient aus Sputterrate und Reaktivgaspartialdruck kann aus einem Quotienten aus einer Material- und Reaktivgaspartialdruck-Plasmalinienintensität bestimmt werden. Mit Material ist hierbei das Material der Sputterkathode gemeint; im vorliegenden Fall Silizium. Eine derartige Zweilinienmessung hat den Vorteil, dass das Ergebnis relativ unabhängig von einer Verschmutzung eines Lichtleitereintrittsfensters ist, durch das die entsprechenden Emissionslinien gemessen werden.

Typische Werte für die vorliegende Einrichtung sind für den Argonfluss 40 sccm/min und für den Sauerstofffluss 30 sccm/min im Bereich der Sputtereinrichtung. Bevorzugt wird ein Sauerstoffpartialdruck aus dem Signal einer im Bereich der Sputtereinrichtung angeordneten Lambdasonde bestimmt. Die typische Leistung einer derartigen Dual Magnetronkathoden Station bei dem erfindungsgemäßen Verfahren liegt im Bereich von 4 KW. Im Bereich der Plasmaquelle ist der typische Sauerstofffluss in einem Bereich von 20 sccm/min, während der Argonfluss in einem Bereich von 2 sccm/min liegt. Die Leistung bei einem RF-Betrieb liegt in einem Bereich um 1 KW.

Zur Regelung der Sputtereinrichtung 3, 7 und der Plasmaquelle 5 sowie der Bewegung der Substrate ist eine zeichnerisch nicht dargestellte Steuereinheit vorgesehen. Die Regelung erfolgt in einem Parameterraum, in dem Kennlinien bzw. Kennfelder aufgespannt sind, wie bereits genauer erläutert wurde. Bei einer bevorzugten Ausführungsform der Erfindung ist vorgesehen, dass ein Signal des optischen Monitors 8 herangezogen wird, um die Betriebsparameter zur Optimierung der optischen Qualität, insbesondere zur Minimierung der optischen Verluste der abgeschiedenen Schicht einzustellen. Dies erfolgt vorzugsweise online. Ebenso ist eine derartige Regelung schichtweise oder bei einem Übergang von einer Schicht zur nächsten vorgesehen. Besonders bevorzugt ist die Verwendung des optischen Signals für die Durchführung einer Führungsregelung zur Berücksichtigung von Langzeitdriften in den Schichteigenschaften, wie Transmission, Reflektion, und/oder optischer Verluste. Ferner wird die Funktion der die Sputtereinrichtung 3,7 und die Plasmaquelle 5 umfassenden Gesamtvorrichtung in Hinblick auf optische Eigenschaften der abgeschiedenen und modifizierten Schicht oder in Hinblick auf die Geschwindigkeit der Schichtherstellung optimiert. Hierzu werden beispielsweise mittels der Steuereinrichtung entsprechende Arbeitspunkte auf einer Kennlinie bei anschließender Plasmaeinwirkung gewählt und ein Optimierungswert bestimmt.

Optisches Monitoring kann unmittelbar nach jedem Sputtern durch die Sputtereinrichtung 3, 7 und/oder nach einer Plasmaeinwirkung durch die Plasmaquelle 5 auf mindestens einem Substrat erfolgen.

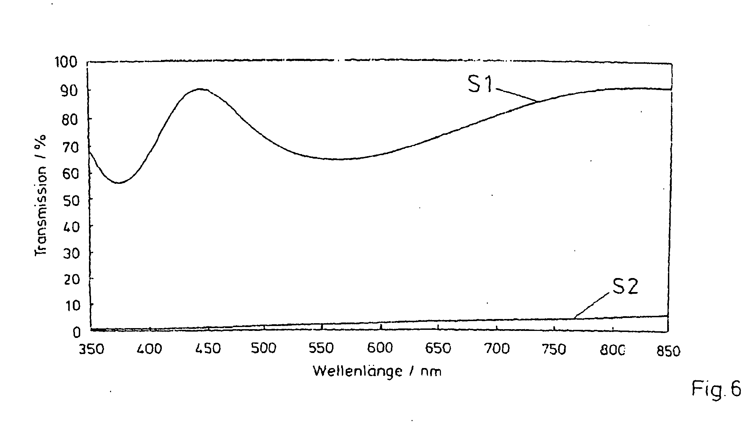

Fig. 6 zeigt ein Beispiel der optischen Transmission einer mit dem erfindungsgemäßen Verfahren hergestellten Schicht als Funktion der Wellenlänge (obere Kurve S₁) im Vergleich mit einer Schicht, welche nach der unterstöchiometrischen Abscheidung nicht dem Sauerstoffplasma aus der Plasmaquelle 5 ausgesetzt wurde (untere Kurve S₂). Die Beschichtungsparameter der beiden Schichten sind bis auf die Oxidation im Bereich der Plasmaquelle 5 gleich. Die unterstöchiometrische Schicht zeigt eine sehr geringe Transmission dafür aber sehr hohe Verluste, so dass diese als Antireflexschicht oder Filter oder dergl. unbrauchbar ist. Offenbar ist zu erkennen, dass die Oxidation durch die Plasmaeinwirkung eine sehr effektive Verbesserung der Schichteigenschaften ermöglicht (obere Kurve S₁).

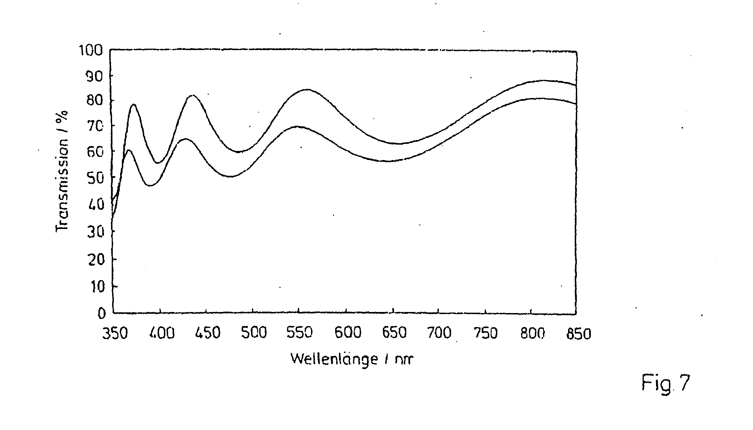

Fig. 7 zeigt ein Beispiel einer optischen Transmission einer Schicht als Funktion der Wellenlänge mit der Substratgeschwindigkeit als Parameter der Kurvenschar. Bei einer hohen Geschwindigkeit von z.B. 180 oder 120 U/min ist die optische Transmission der Schicht höher (obere Kurve) als nur mit halber Geschwindigkeit von z.B. 60 U/min (untere Kurve).

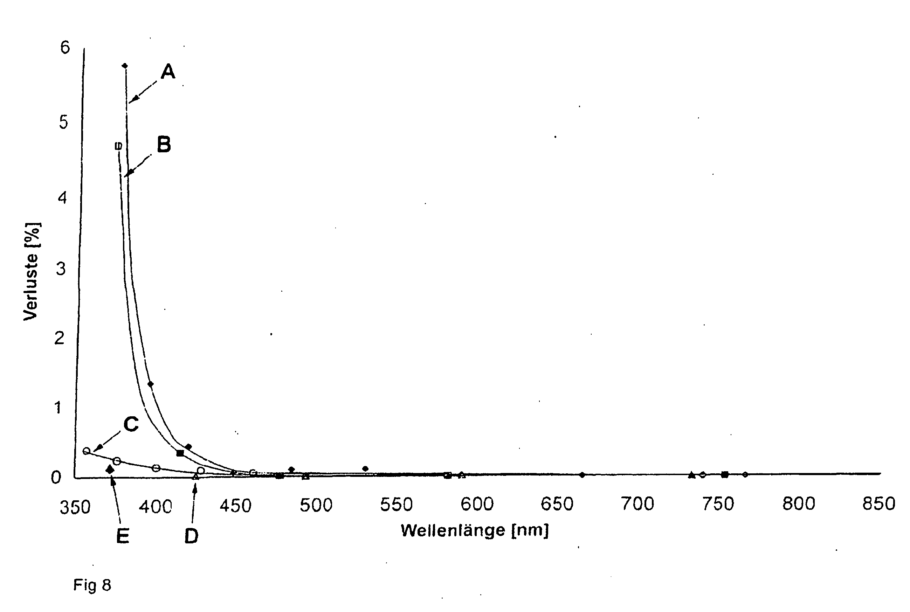

Fig. 8 zeigt Beispiele von Einzelschichten unterschiedlicher Dicke, die gemäß der Erfindung hergestellt wurden. Hierbei bezeichnen die Kurven A und B Nb₂O₅-Schichten mit einer Dicke von 1.000 nm bzw. 500 nm. Die Kurve C bezeichnet eine Ta₂O₅-Einzelschicht mit einer Dicke von 1.000 nm. Die Kurven D und E bezeichnen SiO₂-Schichten mit 1.000 nm bzw. 500 nm Dicke. Erkennbar ist, dass die optischen Verluste von dem verwendeten Material, von der Schichtdicke und der Wellenlänge abhängig sind. Insgesamt sind die optischen Verluste sehr klein und steigen nur im Bereich der Absorptionskante des betreffenden Materials an.

Erfindungsgemäß abgeschiedene Einzelschichten aus einem hochbrechenden Material wie Nb₂O₅, Ta₂O₅, TiO₂, ZrO₂, Al₂O₃ erfordern für einen geringen optischen Verlust eine Abscheidung bei dem reaktiven Sputtern mit nur geringem Sauerstoffdefizit, wobei die Schichten danach dem reaktiven Plasma der Plasmaquelle ausgesetzt werden. Die Energie der Teilchen des reaktiven Plasmas der Plasmaquelle 5 ist dabei bevorzugt kleiner als 50 eV. Für niederbrechende Einzelschichten wie SiO₂ kann ein geringer optischer Verlust auch mit einem größeren Sauerstoffdefizit beim reaktiven Sputtern und nachfolgender Einwirkung des reaktiven Plasmas der Plasmaquelle erreicht werden.

Erfindungsgemäß ergibt sich eine ausgezeichnete optische Qualität der Schichten, die zunächst substöchiometrisch mit einem definierten Sauerstoffmangel hergestellt und anschließend durch Plasmaeinwirkung zum stöchiometrischen Oxid aufoxidiert werden. Pro Umlauf wird typischerweise 0,2 bis 0,4 nm abgeschieden. Die abgeschiedene Schicht ist vorzugsweise röntgenamorph oder nanokristallin mit einer glatten Oberfläche, weist jedoch gleichzeitig eine dichte Struktur frei von Hohlräumen sogenannten voids auf, so dass eine Vermeidung von Wassereinbau aus der Atmosphäre erreicht wird, was ansonsten zu unerwünschten Brechwertänderungen führen würde. Die verbesserte Oberflächenstruktur ist wesentlich auf die Plasmaeinwirkung zurückzuführen, die insofern eine im Stand der Technik übliche Beaufschlagung des Substrats mit einer Bias - Spannung ersetzen kann.

## Patentansprüche

1. Verfahren zur Herstellung einer Schicht (1) auf einem bewegbaren Substrat (2) in einer Vakuumkammer (10) mit einem Restgas mittels einer Sputtereinrichtung (3, 7), wobei die Schicht (1) aus zumindest zwei Konstituenten gebildet wird und zumindest ein erster Konstituent ein Sputtermaterial der Sputtereinrichtung (3, 7) und zumindest ein zweiter Konstituent eine Reaktivkomponente des Restgases ist, wobei im Sputtergas die Partialdrücke von Gasen unabhängig voneinander eingestellt werden können, **dadurch gekennzeichnet, dass** folgende Schritte vorgesehen sind:
- unter Zuführung einer Reaktivkomponente reaktive Abscheidung einer Schicht (1) mit einem vorgegebenen stöchiometrischen Defizit des zweiten Konstituenten in einem räumlichen Bereich der Sputtereinrichtung (3, 7) auf dem Substrat (2), wobei der Partialdruck der Reaktivkomponente im Bereich der Sputtereinrichtung (3, 7) im wesentlichen unabhängig vom Partialdruck der Reaktivkomponente im Bereich der Plasmaquelle (5) eingestellt wird,
- Bewegung des Substrats (2) mit der abgeschiedenen Schicht (1) in einen räumlichen Bereich einer Plasmaquelle (5), die in einem vorgegebenen Abstand von der Sputtereinrichtung (3, 7) in der Vakuumkammer (10) angeordnet und durch Blenden von der Sputtereinrichtung (3,7) getrennt ist, welche Durchlässe für zumindest ein Substrat (2) aufweisen,
- Modifizierung der Struktur und/oder Stöchiometrie der Schicht (1) durch Plasmaeinwirkung der Plasmaquelle (5) und unter Zuführung einer vorgegebenen Menge der Reaktivkomponente, zur Verringerung eines optischen Verlustes der Schicht (1), wobei der Partialdruck der Reaktivkomponente im Bereich der Plasmaquelle (5) im wesentlichen unabhängig vom Partialdruck der Reaktivkomponente im Bereich der Sputtereinrichtung (3, 7) eingestellt wird.

2. Verfahren nach Anspruch 1, **dadurch gekennzeichnet, dass** zur Erhöhung der optischen Transmission das Substrat (2) an der Sputtereinrichtung (3, 7) und an der Plasmaquelle (5) auf einem Substrat-Drehteller als Transporteinrichtung (6) mit einer Geschwindigkeit zwischen 120 U/min und 180 U/min vorbei bewegt wird.

3. Verfahren nach Anspruch 1 oder 2, **dadurch gekennzeichnet, dass** ein optisches Monitoring nach Abscheidung einer vorgegebenen Schichtdicke zur Einstellung von optischen Eigenschaften der Schicht (1) vorgesehen ist.

4. Verfahren nach zumindest einem der vorhergehenden Ansprüche, **dadurch gekennzeichnet, dass** ein Gehalt der Reaktivkomponente in der Schicht (1) bis zur stöchiometrischen Zusammensetzung erhöht wird.

5. Verfahren nach zumindest einem der vorhergehenden Ansprüche, **dadurch gekennzeichnet, dass** die Reaktivkomponente Sauerstoff, Kohlenstoff und/oder Stickstoff ist.

6. Verfahren nach zumindest einem der vorhergehenden Ansprüche, **dadurch gekennzeichnet, dass** eine Plasmaeinwirkung mit einem Plasma einer Plasmaquelle (5) erfolgt, welches zumindest die Reaktivkomponente im Plasma enthält.

7. Verfahren nach zumindest einem der vorhergehenden Ansprüche, **dadurch gekennzeichnet, dass** die Schicht (1) von der substöchiometrischen Zusammensetzung zu einer stöchiometrischen Verbindung modifiziert wird.

8. Verfahren nach zumindest einem der vorhergehenden Ansprüche, **dadurch gekennzeichnet, dass** ein Gasfluss der Reaktivkomponente in Abhängigkeit von einer abgeschiedenen Schichtdicke und/oder einer Zeitdauer der Modifizierung und/oder einer Anzahl der Vorbeiführungen an der Plasmaquelle (5) gesteuert oder geregelt wird.

9. Vorrichtung zur Herstellung einer Schicht (1) auf einem Substrat (2) mittels einer Sputtereinrichtung (3, 7) in einer Vakuumkammer (10) mit einem Restgas, wobei die Schicht (1) aus zumindest zwei Konstituenten gebildet wird und zumindest ein erster Konstituent ein Sputtermaterial der Sputtereinrichtung (3, 7) und zumindest ein zweiter Konstituent eine Reaktivkomponente des Restgases ist, wobei die Vorrichtung
- Mittel zur reaktiven Abscheidung einer Schicht (1) auf dem Substrat (2) unter Zuführung einer Reaktivkomponente mit einem vorgegebenen stöchiometrischen Defizit des reaktiven Bestandteils in einem räumlichen Bereich (A, C) der Sputtereinrichtung (3,7),
- eine Transporteinrichtung (6) zur Bewegung des Substrats (2) mit der abgeschiedenen Schicht (1) in einen räumlichen Bereich (B) einer Plasmaquelle (5), die in einem vorgegebenen Abstand von der Sputtereinrichtung (3, 7) in der Vakuumkammer (10) angeordnet ist und
- Mittel zur Modifizierung der Struktur und/oder Stöchiometrie der Schicht (1) durch
Plasmaeinwirkung der Plasmaquelle (5) in einem räumlichen Bereich (B) umfasst, **dadurch gekennzeichnet, dass**
- Mittel vorgesehen sind, um die Partialdrücke von Gasen im Sputtergas unabhängig voneinander einzustellen,
- der Bereich (A, C) der Sputtereinrichtung (7) und der Bereich (B) der Plasmaquelle (5) durch Blenden getrennt sind, welche Durchlässe für zumindest ein Substrat (2) aufweisen,
- der Bereich (A,C) der Sputtereinrichtung (7) eine eigene Gaszuführung sowie eine eigene Pumpenversorgung und der Bereich (B) der Plasmaquelle (5) eine eigene Gaszuführung sowie eine eigene Pumpenversorgung aufweist,
- im Bereich (B) der Plasmaquelle (5) die Reaktivkomponente zur Verringerung eines optischen Verlustes der Schicht (1) in einer vorgegebenen Menge zuführbar ist.

10. Vorrichtung nach Anspruch 9, **dadurch gekennzeichnet, dass** die Transporteinrichtung als Substrat-Drehteller ausgelegt ist und ausgelegt ist für eine Bewegung des Substrats an der Sputtereinrichtung (3, 7) und an der Plasmaquelle (5) vorbei mit einer Geschwindigkeit zwischen 120 U/min und 180 U/min.

11. Vorrichtung nach Anspruch 9 oder 10, **dadurch gekennzeichnet, dass** die Transporteinrichtung (6) als Substrat-Drehteller oder trommelförmig mit einer einstellbaren Geschwindigkeit ausgebildet ist.

12. Vorrichtung nach einem der Ansprüche 9 bis 11, **dadurch gekennzeichnet, dass** als Sputtereinrichtung (3, 7) eine Magnetron-unterstützte Kathodenzerstäubungsquelle vorzugsweise mit zwei nebeneinander liegenden Magnetron-Anordnungen vorgesehen ist.

## Claims

1. Method for producing a coating (1) on a moveable substrate (2) in a vacuum chamber (10) with a residual gas by means of a sputtering device (3, 7), wherein the coating (1) is formed from at least two constituents and at least one first constituent is a sputtering material of the sputtering device (3, 7) and at least one second constituent is a reactive component of the residual gas, wherein the partial pressures of gases can be set in a manner independent of one another in the sputtering gas, **characterized in that** the following steps are provided:
- reactive deposition of a coating (1) with a prespecified stoichiometric deficit of the second constituent in a spatial region of the sputtering device (3, 7) on the substrate (2) while simultaneously feeding in a reactive component, wherein the partial pressure of the reactive component in the region of the sputtering device (3, 7) is set in a manner substantially independent of the partial pressure of the reactive component, in the region of the plasma source (5),
- movement of the substrate (2) with the deposited coating (1) into a spatial region of a plasma source (5) which is arranged in the vacuum chamber (10) at a prespecified spacing from the sputtering device (3, 7) and is separated from the sputtering device (3, 7) by screens which have through-openings for at least one substrate (2),
- modification of the structure and/ox stoichiometry of the coating (1) by way of plasma action of the plasma source (5) and while simultaneously feeding in a prespecified quantity of the reactive component, in order to reduce an optical loss of the coating (1), wherein the partial pressure of the reactive component in the region of the plasma source (5) is set in a manner substantially independent of the partial pressure of the reactive component in the region of the sputtering device (3, 7).

2. Method according to Claim 1, **characterized in that**, in order to increase the optical transmittance, the substrate (2) is moved on a substrate rotating disc as a transport device (6) past the sputtering device (3, 7) and the plasma source (5) with a speed of between 120 rpm and 180 rpm.

3. Method according to Claim 1 or 2, **characterized in that** optical monitoring is provided after deposition of a prespecified coating thickness in order to set optical properties of the coating (1).

4. Method according to at least one of the preceding claims, **characterized in that** a content of the reactive component in the coating (1) is increased to the stoichiometric composition.

5. Method according to at least one of the preceding claims, **characterized in that** the reactive component is oxygen, carbon and/or nitrogen.

6. Method according to at least one of the preceding claims, **characterized in that** a plasma action is effected with plasma of a plasma source (5), which plasma contains at least the reactive component in the plasma.

7. Method according to at least one of the preceding claims, **characterized in that** the coating (1) is modified from the substoichiometric composition to a stoichiometric compound.

8. Method according to at least one of the preceding claims, **characterized in that** a gas flow of the reactive component is controlled or regulated as a function of a deposited coating thickness and/or a period of modification and/or a number of passages past the plasma source (5).

9. Apparatus for producing a coating (1) on a substrate (2) in a vacuum chamber (10) with a residual gas by means of a sputtering device (3, 7), wherein the coating (7.) is formed from at least two constituents and at least one first constituent is a sputtering material of the sputtering device (3, 7) and at least one second constituent is a reactive component of the residual gas, wherein the apparatus comprises
- means for the reactive deposition of a coating (1) on the substrate (2) while feeding in a reactive component with a prespecified stoichiometric deficit of the reactive constituent in a spatial region (A, C) of the sputtering device (3, 7),
- a transport device (6) for moving the substrate (2) with the deposited coating (1) into a spatial region (B) of a plasma source (5) which is arranged in the vacuum chamber (10) at a prespecified spacing from the sputtering device (3, 7), and
- means for modifying the structure and/or stoichiometry of the coating (1) by way of plasma action of the plasma source (5) in a spatial region (B),
**characterized in that**
- means are provided to set the partial pressures of gases in the sputtering gas in a manner independent of one another,
- the region (A, C) of the sputtering device (7) and the region (B) of the plasma source (5) are separated by screens which have through-openings for at least one substrate (2),
- the region (A, C) of the sputtering device (7) has a dedicated gas feed and a dedicated pump supply and the region (B) of the plasma source (5) has a dedicated gas feed and a dedicated pump supply,
- in the region (B) of the plasma source (5) the reactive component is feedable in a prespecified amount in order to reduce an optical loss of the coating (1).

10. Apparatus according to Claim 9, **characterized in that** the transport device is adapted as a substrate rotational disc and is adapted for moving the substrate past the sputtering device (3, 7) and the plasma source (5) with a speed of between 120 rpm and 180 rpm.

11. Apparatus according to Claim 9 or 10, **characterized in that** the transport device (6) is configured as a substrate rotating disc or in the form of a drum with a settable speed.

12. Apparatus according to one of Claims 9 to 11, **characterized in that** a magnetron-assisted cathode sputtering source, preferably with two magnetron arrangements located next to each other, is provided as sputtering device (3, 7).

## Revendications

1. Procédé pour la production d'une couche (1) sur un substrat mobile (2) dans une chambre à vide (10) avec un gaz résiduel au moyen d'un dispositif de pulvérisation cathodique (3, 7), la couche (1) étant formée à partir d'au moins deux constituants et au moins un premier constituant étant un matériau de pulvérisation cathodique du dispositif de pulvérisation cathodique (3, 7) et au moins un deuxième constituant étant un composant réactif du gaz résiduel, dans le gaz de pulvérisation cathodique les pressions partielles des gaz pouvant être ajustées indépendamment les unes des autres, **caractérisé en ce que** sont prévues les étapes suivantes :
- avec apport d'un composant réactif dépôt réactif d'une couche (1) avec un déficit stoechiométrique préétabli du deuxième constituant dans une zone spatiale du dispositif de pulvérisation cathodique (3, 7) sur le substrat (2), la pression partielle du composant réactif dans la zone du dispositif de pulvérisation cathodique (3, 7) étant ajustée essentiellement indépendamment de la pression partielle du composant réactif dans la zone de la source de plasma (5),
- mise en mouvement du substrat (2) avec la couche (1) déposée, dans une zone spatiale d'une source de plasma (5) qui est placée à une distance préétablie du dispositif de pulvérisation cathodique (3, 7) dans la chambre à vide (10) et est séparée du dispositif de pulvérisation cathodique (3, 7) par des écrans qui comportent des passages pour au moins un substrat (2),
- modification de la structure et/ou de la stoechiométrie de la couche (1) sous l'effet du plasma de à source de plasma (5) et avec apport d'une quantité préétablie du composant réactif, pour la réduction d'une perte optique de la couche (1), la pression partielle du composant réactif dans la zone de la source de plasma (5) étant ajustée essentiellement indépendamment de la pression partielle du composant réactif dans la zone du dispositif de pulvérisation cathodique (3, 7).

2. Procédé selon la revendication 1, **caractérisé en ce que** pour augmenter la transmission optique on fait passer le substrat (2) devant le Dispositif de pulvérisation cathodique (3, 7) et devant la source de plasma (5) en le déplaçant à une vitesse comprise entre 120 tours/min et 180 tours/min sur un plateau tournant pour substrat en tant que dispositif de transport (6).

3. Procédé selon la revendication 1 ou 2, **caractérisé en ce qu'**après dépôt d'une épaisseur de couche préétablie un contrôle optique est prévu pour l'ajustement des propriétés optiques de la couche (1).

4. Procédé selon au moins l'une quelconque des revendications précédentes, **caractérisé en ce qu'**une une teneur en le composant réactif de la couche (1) est augmentée jusqu'à la composition stoechiométrique.

5. Procédé selon au moins l'une quelconque des revendications précédentes, **caractérisé en ce que** le composant réactif est l'oxygène, le carbone ou l'azote.

6. Procédé selon au moins l'une quelconque des revendications précédentes, **caractérisé en ce qu'**un effet de plasma s'effectue avec un plasma d'une source de plasma (5) qui contient au mois le composant réactif dans le plasma.

7. Procédé selon au moins l'une quelconque des revendications précédentes, **caractérisé en ce que** de la composition sous-stoechiométrique la couche (1) est modifiée en un composé stoechiométrique.

8. Procédé selon au moins l'une quelconque des revendications précédentes, **caractérisé en ce qu'**un flux de gaz du composant réactif est dirigé ou réglé en fonction d'une épaisseur de couche déposée et/ou d'une durée de la modification et/ou d'un nombre des passages devant la source de plasma (5).

9. Dispositif pour la production d'une couche (1) sur un substrat (2) au moyen d'un dispositif de pulvérisation cathodique (3, 7) dans une chambre à vide (10) avec un gaz résiduel, la couche (1) étant formée à partir d'au moins deux constituants et au moins un premier constituant étant un matériau de pulvérisation cathodique du dispositif de pulvérisation cathodique (3, 7) et au moins un deuxième constituant étant un composant réactif du gaz résiduel, le dispositif comprenant
- des moyens pour le dépôt réactif d'une couche (1) sur le substrat (2) avec apport d'un composant réactif avec un déficit stoechiométrique préétabli du constituant réactif dans une zone spatiale (A, C) du dispositif de pulvérisation cathodique (3, 7),
- un dispositif de transport (6) pour la mise en mouvement du substrat (2) avec la couche (1) déposée, dans une zone spatiale (B) d'une source de plasma (5) qui est placée à une distance préétablie du dispositif de pulvérisation cathodique (3, 7) dans la chambre à vide (10) et
- des moyens pour la modification de la structure et/ou de la stoechiométrie de la couche (1) sous l'effet du plasma de la source de plasma (5) dans une zone spatiale (B) **caractérisé en ce que**
- sont prévus des moyens pour ajuster indépendamment les unes des autres les pressions partielles des gaz dans le gaz de pulvérisation cathodique,
- la zone (A, C) du dispositif de pulvérisation cathodique (7) et la zone (B) de la source de plasma (5) sont séparées par des écrans qui comportent des passages pour au moins un substrat (2),
- la zone (A, C) du dispositif de pulvérisation cathodique (7) comporte une propre introduction de gaz ainsi qu'une propre alimentation par pompe et la zone (B) de la source de plasma (5) comporte une propre introduction de gaz ainsi qu'une propre alimentation par pompe,
- dans la zone (B) de la source de plasma (5) le composant réactif peut être introduit en une quantité préétablie, pour la réduction d'une perte optique de la couche (1).

10. Dispositif selon la revendication 9, **caractérisé en ce que** le dispositif de transport est conçu sous forme d'un plateau tournant pour substrat et est conçu pour faire passer le substrat devant le dispositif de pulvérisation cathodique (3, 7) et devant la source de plasma (5) à une vitesse comprise entre 120 tours/min et 180 tours/min.

11. Dispositif selon la revendication 9 ou 10, **caractérisé en ce que** le dispositif de transport (6) est réalisé sous forme d'un plateau tournant pour substrat ou en forme de tambour avec une vitesse réglable.

12. Dispositif selon l'une quelconque des revendications 9 à 11, **caractérisé en ce que** comme dispositif de pulvérisation cathodique (3, 7) est prévue une source de pulvérisation cathodique assistée par magnétron de préférence avec deux dispositifs magnétron placés l'un à côté de l'autre.
